# EUROPEAN PATENT SPECIFICATION

(11) **EP 3 491 676 B1**
(45) Date of publication and mention of the grant of the patent: **30.09.2020**
(21) Application number: 17745957.5
(22) Date of filing: 27.07.2017
(51) Int. Cl.: H01L 33/06, H01L 33/30, H01L 33/00, H01L 33/10

(54) **III-P LIGHT EMITTING DEVICE WITH A SUPERLATTICE**
III-P-LICHTEMITTIERENDE VORRICHTUNG MIT EINEM SUPERGITTER
DISPOSITIF ELECTROLUMINESCENT III-P AYANT UN SUPER RÉSEAU

(30) Priority: 28.07.2016 US 201662367935 P; 29.09.2016 EP 16191414; 26.07.2017 US 201715660602
(43) Date of publication of application: 05.06.2019
(73) Proprietor: Lumileds LLC, San Jose, CA 95131 (US)
(72) Inventor: BHUSAL, Lekhnath, San Jose California 95131 (US); CHUNG, Theodore, San Jose California 95131 (US); CHOI, Suk, San Jose California 95131 (US); NELSON, Erik C., Pleasanton, California 94566 (US); DEB, Parijat P., San Jose California 95131 (US)
(74) Representative: ter Heegde, Paul Gerard Michel
(86) International application number: PCT/US2017/044113
(87) International publication number: WO 2018/022849

(56) References cited:
- EP-A1- 1 017 113
- KR-A- 20140 070 764
- US-A1- 2002 104 996
- US-A1- 2007 284 607
- US-A1- 2013 270 520
- US-B1- 6 417 522
- Fred E. Schubert: "Light-Emitting Diodes", , 1 January 2006 (2006-01-01), pages 209-211, XP055334879, Retrieved from the Internet: URL:http://www.ifsc.usp.br/~lavfis2/BancoA postilasImagens/ApConstantePlanck/ApCtePla nck2013/LIGHT-EMITTING%20DIODES.e-05218653 87-2e.pdf [retrieved on 2017-01-12]

## Description

### RELATED APPLICATIONS

The present application claims priority to U.S. Provisional Patent Application No. 62/367,935, filed July 28, 2016, U.S. Patent Application No. 15/660,602, filed July 26, 2017, and European Patent Application No. 16191414.8, filed September 29, 2016.

### BACKGROUND

### DESCRIPTION OF RELATED ART

Light emitting diodes (LEDs) are widely accepted as light sources in many applications that require low power consumption, small size, and high reliability. Energy-efficient diodes that emit light in the yellow-green to red regions of the visible spectrum often contain active layers formed of an AlGaInP alloy. Energy-efficient diodes that emit light in the UV to blue to green regions of the visible spectrum often contain active layers formed of a III-nitride alloy.

Fig. 1 is a cross-sectional view of a prior art AlGaInP device, described in more detail in US 6,057,563. The device of Fig. 1 comprises: a GaAs substrate 10 of a first conductivity-type; a Bragg reflector layer 11 consisting of AlAs/GaAs and formed upon the substrate 10; an AlGaInP confinement layer 12 of the first conductivity-type grown upon the Bragg reflector layer 11; a conductive AlGaInP active layer 13 grown upon the AlGaInP confinement layer 12; an AlGaInP confinement layer 14 of a second conductivity-type grown upon the AlGaInP active layer 13; a plurality of conductive GaInP/AlGaInP superlattice layers 15 grown upon the AlGaInP confinement layer 14; an ohmic contact layer 16 of the second conductivity-type grown upon the conductive AlGaInP superlattice layer 15; a front contact 17 formed on top of the ohmic contact layer 16; and a back contact 18 formed on the back side of the substrate 10.

US 6,057,563 teaches "the LED with light transparent window according to the present invention can provide a bright and uniform luminance by enabling current to flow uniformly through the entire LED chip and increasing the transparency of the window layer."

Document US 2013/270520 A1 discloses a light emitting element for a display, having a superlattice layer between an active layer unit and an n-type cladding layer.

### SUMMARY

In one aspect a light emitting device is provided as recited in claim 1.

In yet another aspect, a method is provided as recited in claim 7.

### BRIEF DESCRIPTION OF THE DRAWINGS

Fig. 1 illustrates a prior art AlGaInP LED device.
Fig. 2 is a cross-sectional view of an AlGaInP device structure according to the invention grown on a substrate.
Fig. 3 is a cross-sectional view of an AlGaInP device structure of Fig. 2 after forming contacts and removing the growth substrate.
Fig. 4 is a top view of a thin film AlInGaP device, such as the device of Fig. 3.

### DETAILED DESCRIPTION

The III-P or AlₓGa₁₋ₓInP alloy system is critical for making light emitting diodes (LEDs) and lasers emitting light having a peak wavelength in the wavelength range of about 580 nm (amber) to 770 nm (far red). This range of wavelengths is achieved by adjusting the aluminum-gallium ratio during the growth of the alloy. Increased aluminum (x) composition in the light emitting layers provides shorter wavelengths. One example of an LED has a p-i-n junction epitaxially grown on an absorbing GaAs substrate. The first layer is an n-type lower confining layer (LCL) of AlₓGa₁₋ₓInP, epitaxially grown on the GaAs substrate. An active i-layer of AlₓGa₁₋ₓInP with suitable aluminum-gallium ratio to provide a desired wavelength is then epitaxially grown on the n-type LCL. A p-type upper confinement layer (UCL) of AlₓGa₁₋ₓInP is then epitaxially grown on the active layer. The p-i-n junction has a single light emitting layer, and is a double heterostructure. As an alternative to a single light emitting layer, a III-P LED may have a multiple quantum well light emitting region (also referred to as an active region) sandwiched between n- and p-type regions. A multiple quantum well light emitting regions includes multiple, quantum well light emitting layers, separated by barrier layers. In a surface emitting LED, a front metal electrode is formed on the emitting face of the LED and a back metal electrode is formed in the back.

For a given active layer design, efficient LED operation depends on efficient current injection from metal electrodes to the corresponding n- and p-type layers of the LED chip. Ideally, current is distributed as evenly as possible over the entire active region of an LED, without blocking or reflecting light emitted from the active region. Ideal current distribution requires that the n-and p-type layers have the lowest possible sheet resistances, to avoid any current crowding under or near the metal electrodes. Ideal current distribution also requires that the n- and p-type layers have bandgaps larger than the emission wavelength of the active region, to avoid any absorption and/or reflection. Reducing aluminum composition in AlₓGa₁₋ₓInP does reduce the sheet resistance, but also reduces the bandgap of AlₓGa₁₋ₓInP, which may increase absorption of emission from the active layer. This absorption becomes severe at shorter wavelength emitting LEDs.

According to the invention, an AlGaInP device includes a multiple-layered superlattice semiconductor structure, which may reduce sheet resistance to prevent current crowding in n-contact of an LED, while maintaining a sufficiently high bandgap to prevent significant absorption of light emitted by the active layer of the LED. The superlattice is formed on the n-type side of the active region, and may comprise n-type layers.

Depending on the context, as used herein, "AlGaInP" or "AlInGaP" may refer in particular to a quaternary alloy of aluminum, indium, gallium, and phosphorus, or in general to any binary, ternary, or quaternary alloy of aluminum, indium, gallium, and phosphorus. "III-nitride" may refer to a binary, ternary, or quaternary alloy of any group III atom (such as aluminum, indium, and gallium) and nitrogen. For instance, "AlGaInP" may include (AlₓGa₍₁₋ₓ₎)ᵣIn₍₁₋ᵣ₎P where 0 < x < 1, 0 < r < 1. Depending on the context, as used herein, "contact" may refer in particular to a metal electrode, or in general to the combination of a semiconductor contact layer, a metal electrode, and any structures disposed between the semiconductor contact layer and the metal electrode.

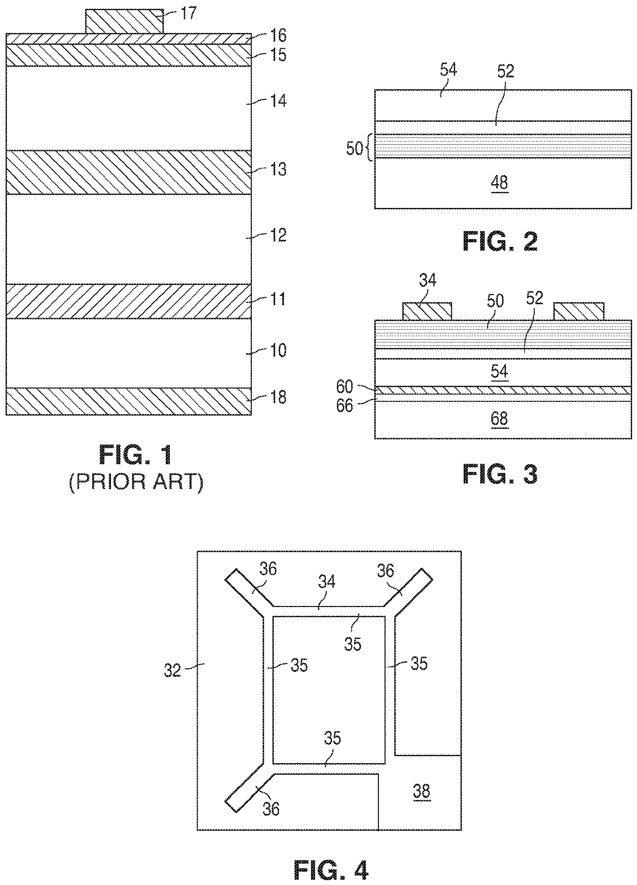

Fig. 2 is a cross sectional view of a semiconductor device structure grown over a growth substrate 48, according to some embodiments. Growth substrate 48 is often GaAs, though any suitable growth substrate may be used.

An etch stop layer (not shown) may be grown over substrate 48. The etch stop layer may be any material that may be used to stop an etch used to later remove substrate 48. The etch stop layer may be, for example, InGaP, AlGaAs, or AlGaInP. The material of the etch stop layer may be lattice-matched to the growth substrate (typically GaAs), though it need not be. Etch stop layers that are not lattice matched to the growth substrate may be thin enough to avoid relaxation and/or may be strain compensated. The thickness of the etch stop layer depends on the selectivity of the etch solutions used to remove the GaAs substrate; the less selective the etch, the thicker the etch stop layer. An AlGaAs etch stop layer may be, for example, between 2000 and 5000 Å, though a thicker etch stop layer may be used if the etch stop layer is used to texture the emitting surface of the device, as described below. The composition x of an AlₓGa₁₋ₓAs etch stop layer may be, for example, between 0.50 and 0.95.

The device layers, including at least one light emitting layer in a light emitting or active region sandwiched between an n-type region and a p-type region, are grown over the etch stop layer.

According to the invention, the n-type region 50 includes a multiple-layered superlattice semiconductor structure. The superlattice may provide a low sheet resistance and tuneable bandgap. The superlattice includes a stack of alternating layers of lower aluminum content AlₓGa₁₋ₓInP and higher aluminum content AlₓGa₁₋ₓInP (wherein 0 < x < 1). The lower aluminum content layers in the superlattice may provide a path of lower sheet resistance for better current spreading. The superlattice may be designed to obtain a desired bandgap by appropriately choosing the thickness and the aluminum content of the layers in the superlattice. In some embodiments, the lower aluminum content layers in the superlattice may act as quantum wells, surrounded by the higher aluminum content layers, which may act as quantum barriers. Thin enough quantum barriers may cause the energy states of the quantum wells to resonate and generate minibands for electrons and holes, which define the bandgap of the superlattice. Minibands of the superlattice can be tuned to provide a bandgap that lies between the bandgaps of the lower aluminum content layers and the higher aluminum content layers.

The Al composition of the AlₓGa₁₋ₓInP LCL is at least x = 0.3 (30% Al) and no more than x = 0.65 (65% Al). An AlₓGa₁₋ₓInP LCL with 30% Al has a bandgap of about 2.08eV and an absorption edge of about 596 nm. On the other end, an AlₓGa₁₋ₓInP LCL with 65% Al has a bandgap of about 2.23eV and an absorption edge of about 553 nm. The 30% Al LCL may be suitable for an LED with a peak emission wavelength greater than 660 nm in some embodiments. For LEDs with peak emission wavelengths below 660 nm, the Al composition in the LCL may be increased, reaching up to 65% for a peak emission wavelength of about 590 nm in some embodiments. For a given superlattice structure, A1 concentration of the lower aluminum content AlGaInP layers in the superlattice and higher aluminum content AlGaInP layers in the superlattice ranges from 30% to 65%. Bandgap (or absorption edge) of the superlattice layer targeted for a given LED color not only depends on the Al concentration, but also on the thicknesses of the individual layers. In one embodiment, the superlattice includes 100 Å thick Al_{0.45}Ga_{0.55}InP layers alternating with 100 Å thick Al_{0.35}Ga_{0.65}InP layers, which provides an effective bandgap of about 2.14 and an absorption edge of about 578 nm. This bandgap and absorption edge is very closely matched to a bulk (i.e., single layer of uniform composition) AlInGaP layer with 40% A1. To achieve a higher bandgap (or lower absorption edge), the thickness of the lower A1 content layers may be reduced, and/or the A1 composition in either or both of the layers may be increased.

The higher and lower aluminum composition layers in the superlattice may have a dopant concentration of at least 1x10¹⁷/cm³ in some embodiments, no more than 1x10¹⁹/cm³ in some embodiments, at least 0.5x10¹⁸/cm³ in some embodiments, and no more than 1.5x10¹⁸/cm³ in some embodiments. The higher and lower aluminum composition layers may be doped differently. In some embodiments, the superlattice layers may be doped in gradient with the doping profile changing across the superlattice. Any suitable dopants may be used, including, for example, n-type dopant(s), Si, and Te. The doping could be modulated to match the modulation of composition. For example, higher bandgap layers may be more highly doped, and lower bandgap layers may be less doped. Alternatively, higher bandgap layers may be less doped, and lower bandgap layers may be more highly doped. The n-type region 50 may include a non-uniform doping concentration, such as one or more thick regions doped at 1x10¹⁸ cm⁻³, and one or more thin regions that are doped more heavily, up to, for example, 1x10¹⁹ cm⁻³. These highly doped regions may be doped with Te, Si, S, or other suitable dopants, and the high doping concentration can be achieved either by epitaxial growth, by dopant diffusion, or both.

The individual layers in the superlattice may be at least 5 nm in some embodiments, no more than 100 nm thick in some embodiments, and no more than 20 nm thick in some embodiments. The total thickness of the entire superlattice may be at least 1 µm thick in some embodiments, no more than 8 µm thick in some embodiments, at least 2 µm thick in some embodiments, and no more than 5 µm thick in some embodiments. The superlattice may include at least 100 pairs of lower and higher Al composition layers in some embodiments, no more than 1600 pairs in some embodiments, and no more than 400 pairs in some embodiments.

According to the invention, n-type region 50 includes a separate AlGaInP n-contact layer, on which a metal n-contact is formed. According to the invention, a metal n-contact is formed on the first or other layer pair in the superlattice. A separate n-contact layer may be a layer with doping and/or composition that is optimized for contact formation, rather than for the superlattice.

In some embodiments, the superlattice as a whole is lattice-matched to the growth substrate, often GaAs. In some embodiments, individual layers of the superlattice layer may be strained (i.e., not lattice matched to the growth substrate). In some embodiments, individual layers of the superlattice layer may be lattice-matched to the growth substrate.

In one example, the superlattice includes thin layers of AlGaInP with 45% aluminum, which act as barrier layers to thin layers of AlGaInP with 35% aluminum, which act as quantum well layers. By choosing the correct thickness of the 35% and 45% aluminum layers, the effective bandgap of the superlattice can be tuned to the bandgap of a single layer of uniform composition AlGaInP with 40% aluminum.

In one example, the superlattice includes first layers comprising AlₓGa₁₋ₓInP, wherein x > 0, and second layers comprising Al_{y}Ga_{1-y}InP, wherein y > 0. The first layers may have a composition 0.3 ≤ x ≤ 0.4 and the second layers may have a composition 0.4 ≤ y ≤ 0.5. In one example, the superlattice includes first layers comprising AlₓGa₁₋ₓInP, wherein x > 0, and second layers comprising Al_{y}Ga_{1-y}InP, wherein y > 0. According to the invention, the first layers have a composition 0.2 ≤ x ≤ 0.5 and the second layers may have a composition 0.3 ≤ y ≤ 0.65.

In one example, the superlattice includes alternating layers of 10 nm thick (Al_{0.35}Ga_{0.65})_{0.51}In_{0.49}P and 10 nm thick (Al_{0.45}Ga_{0.55})_{0.51}In_{0.49}P. The superlattice includes 225 pairs of these layers, grown epitaxially over a GaAs substrate. This superlattice layer provides an effective bandgap of ∼2.14 (absorption edge ∼578nm), and may be used in an LED with a peak emission wavelength of at least 620 nm in some embodiments and no more than 700 nm in some embodiments.

A given superlattice can be used for multiple peak emission wavelengths. The lower limit of emission wavelength is set by the superlattice (determined by the superlattice absorption edge), however any active region with a peak wavelength longer than the lower limit is suitable for use with the superlattice.

The following table illustrates several examples of superlattice structures. Four superlattice structures are illustrated. The thickness and aluminum composition for the lower A1 composition layers and the higher A1 composition layers is given, as well as the effective bandgap. The "Effective WL cut-off" is the wavelength below which light will be absorbed by the superlattice. In some embodiments, the active regions emits little or no light below the cut-off wavelength. In some embodiments, the active region may emit some light that is below the cut-off wavelength, and which may be absorbed by the superlattice (for example, to optimize the conductivity of the layer vs. its absorption edge). The examples given are merely illustrations and not meant to be limiting.

| %Al, low Al layers | Thickness, low Al layers | %Al, high Al layers | Thickness, high Al layers | Effective bandgap | Effective WL cut-off |
|---|---|---|---|---|---|
| 30 | 10nm | 40 | 10nm | 2.1 eV | 590nm |
| 35 | 10nm | 45 | 10nm | 2.14eV | 580nm |
| 45 | 10nm | 55 | 10nm | 2.2 | 564nm |
| 55 | 10nm | 65 | 10nm | 2.24 | 554nm |

A light emitting or active region 52 is grown over n-type region 50. Examples of suitable light emitting regions include a single light emitting layer, and a multiple well light emitting region, in which multiple thick or thin light emitting wells are separated by barrier layers. In one example, the light emitting region 52 of a device configured to emit red light includes (A_{l0.06}G_{a0.94})_{0.5}I_{n0.5}P light emitting layers separated by (A_{l0.65}G_{a0.35})_{0.5}I_{n0.5}P barriers. The light emitting layers and the barriers may each have a thickness between, for example, 20 and 200 Å. The total thickness of the light emitting region may be, for example, between 500 Å and 3 µm.

A p-type region 54 is grown over light emitting region 52. P-Lype region 54 is configured to confine carriers in light emitting region 52. In one example, p-type region 54 is (Al_{0.65}Ga_{0.35})_{0.5}In_{0.5}P and includes a thin layer of high A1 composition to confine electrons. The thickness of p-type region 54 may be on the order of microns; for example, between 0.5 and 3 µm. The proximity of the light emitting layers of the light emitting region to the p-contact through a thin p-type region 54 may also reduce the thermal impedance of the device.

In some embodiments, a p-type contact layer (not shown) may be grown over p-type region 54. The p-type contact layer may be highly doped and transparent to light emitted by the light emitting region 52. For example, the p-type contact layer may be doped to a hole concentration of at least 5x10¹⁸ cm⁻³ in some embodiments, and at least 1x10¹⁹ cm⁻³ in some embodiments. In this case, the p-type contact layer may have a thickness between 100 Å and 1000Å. If the p-type contact layer is not highly doped then the thickness may be increased to as much as 12 µm, for example with a hole concentration up to 5x10¹⁸cm⁻³. In some embodiments, the p-type contact layer is highly doped GaP. For example, a GaP contact layer grown by metal organic chemical vapor deposition may be doped with Mg or Zn, activated to a hole concentration of at least 8x10¹⁸ cm⁻³. The GaP layer may be grown at low growth temperature and low growth rate; for example, at growth temperatures approximately 50 to 200 °C below typical GaP growth temperatures of ∼ 850 °C, and at growth rates of approximately 1% to 10% of typical GaP growth rates of ∼ 5 µm/hr. A GaP contact grown by molecular beam epitaxy may be doped with C to a concentration of at least 1x10¹⁹ cm⁻³. In some embodiments, as an alternative to incorporating dopants during growth, the p-type contact layer may be grown, then the dopants may be diffused into the p-type contact layer from a vapor source after growth, for example by providing a high pressure dopant source in a diffusion furnace or in the growth reactor, as is known in the art.

Fig. 3 illustrates the semiconductor structure of Fig. 2 formed into a device. After growth, a p-contact 60 is formed in electrical contact with p-type region 54 (on p-contact layer, if present, or on p-type region 54). In some embodiments, p-contact 60 is a metal mirror, such as AuZn, with Zn diffusing into the semiconductor. In some embodiments, p-contact 60 includes many small contacts spaced apart on the semiconductor layer, with a dielectric layer formed over the small contacts, such that a majority of the semiconductor surface is covered in a dielectric, which functions as a mirror for much of the emitted light based on the principle of total internal reflection. The dielectric may be covered with a metal that is an excellent mirror but does not make good ohmic contact with the semiconductor, such as Ag or Au. Such a structure is often referred to as a composite or hybrid mirror and is known in the art. In some embodiments, a distributed Bragg reflector is used in place of the single dielectric layer described above. The p-contact 60 may include other materials including, for example, a guard material such as TiW or any other suitable material. The guard layer may seal the reflective metal layer in place and function as a barrier to the environment and other layers.

A bonding layer 66 may be formed over the p-contact 60, and/or on the mount 68 described below. The bonding layer may be, for example, Au or TiAu and may be formed by, for example, evaporation. The device may be temporarily attached to a support, or permanently bonded to a mount 68, through the bonding layer 66, in order to facilitate further processing. The mount may be selected to have a coefficient of thermal expansion (CTE) that is reasonably closely matched to the CTE of the semiconductor layers. The mount may be, for example, GaAs, Si, a metal such as molybdenum, or any other suitable material. A bond is formed between the device and the mount by, for example, thermocompression bonding, or any other suitable technique.

Growth substrate 48 is removed by a technique suitable to the growth substrate material. For example, a GaAs growth substrate may be removed by a wet etch that terminates on an etch-stop layer grown over the growth substrate before the device layers. The semiconductor structure may optionally be thinned. Removing the growth substrate may expose a surface of the n-type region 50, such as a surface of the superlattice.

The surface of n-type region 50 exposed by removing the growth substrate may be roughened to improve light extraction, for example by photoelectrochemical etching, or patterned by, for example, nanoimprint lithography to form a photonic crystal or other light scattering structure. In other embodiments, a light-extracting feature is buried in the structure. The light extracting feature may be, for example, a variation in index of refraction in a direction parallel to the top surface of the device (i.e. perpendicular to the growth direction of the semiconductor layers). In some embodiments, the surface of the p-type region or p-type contact layer may be roughened or patterned prior to forming the p-contact 60. In some embodiments, before or during growth of the semiconductor structure, a layer of low index material is deposited on the growth substrate or on a semiconductor layer and patterned to form openings in the low index material or posts of low index material. Semiconductor material is then grown over the patterned low index layer to form a variation in index of refraction that is disposed within the semiconductor structure.

N-contact metal 34, such as, for example, Au/Ge/Au or any other suitable contact metal or metals, may be deposited on the top surface 32 of the superlattice, then patterned to form an n-contact. For example, a photoresist layer may be deposited and patterned, then covered with the contact metal(s), then the photoresist is removed. Alternatively, the contact metal(s) may be blanket coated, then a pattern formed via photoresist, and some of the metal etched.

Fig. 4 is a top view of a device, illustrating one example of the arrangement of an n-contact metal. As described above, n-contact 34 may be, for example, gold, AuGe, or any other suitable metal. The n-contact 34 may have arms 35 that form a square and extensions 36 that extend from the corners of the square, though it need not. N-contact may have any suitable shape. N-contact arms 35 and extensions 36 may be 1 to 100 microns wide in some embodiments, 1 to 30 microns wide in some embodiments, and 20 to 50 microns wide in some embodiments. The n-contact arms 35 and extensions 36 are generally kept as narrow as possible to minimize light blockage or absorption, but wide enough not to incur excessive electrical contact resistance. The contact resistance increases for widths less than the transfer length _{Lt}, which depends on the metal-to-semiconductor resistance and sheet resistance of the underlying semiconductor n-type layer. The n-contact segment width may be twice _{Lt} since the contact arm injects current from both sides, or 1 to 30 microns for the above-described device, depending on the specific material parameters.

In some embodiments, the n-contact 34 is made highly reflective (R>0.8). In some embodiments, a current-spreading layer is disposed between the n-type region 50 and n-contact 34 in order to improve current spreading, and potentially to minimize the surface of the n-contact thus reducing optical losses. The current-spreading layer material is selected for low optical loss and good electrical contact. Suitable materials for the current-spreading layer include are Indium Tin Oxide, Zinc Oxide, or other transparent conducting oxides.

N-contact 34 connects to a bonding pad 38. Bonding pad 38 is large enough to accommodate a wire bond, wire bridge, or other suitable electrical contact to an external current source. Though in the device of Fig. 4 bonding pad 38 is located in the corner of the device, bonding pad 38 may be located in any suitable position, including, for example, in the center of the device.

After forming n-contact 34, the structure may be heated, for example to anneal n-contact 34 and/or p-contacts 60.

A wafer of devices may then be tested and laser-singulated into individual devices. Individual devices may be placed in packages, and an electric contact such as a wire bond may be formed on the bonding pad 38 of the device to connect the n-contact to a part of the package such as a lead.

In operation, current is injected in the p-type region by contact 60 via the mount. Current is injected in the n-type region by bonding pad 38, on the top surface of the device.

The devices illustrated in Figs. 3 and 4 are thin film devices, meaning that the growth substrate is removed from the final device. The total thickness between the top contact and the top surface of the bonding layers that connect the device to the mount in the thin film devices described above is no more than 20 microns in some embodiments and no more than 15 microns in some embodiments.

Having described the invention in detail, those skilled in the art will appreciate that, given the present disclosure, modifications may be made to the invention without departing from the scope of the invention as defined by the appended claims.

## Claims

1. A light emitting device comprising:
a semiconductor structure comprising a III-P light emitting layer (52) disposed between an n-type region (50) and a p-type region (54), the n-type region comprising a superlattice; and
an n-contact metal (34) on and in contact with a surface of the superlattice opposite the III-P light emitting layer,
the superlattice comprising a plurality of stacked layer pairs,
**characterised in that**
each layer pair comprises a first layer of AlₓGa₁₋ₓInP where 0.2≦x≦50.5 and a second layer of Al_{y}Ga_{1-y}InP where 0.3≦y≦0.65, the first layer having a smaller aluminum composition than the second layer.

2. The light emitting device of claim 1 further comprising: a bottom contact disposed on the p-type region.

3. The light emitting device of claim 1 wherein 0.3≦x≦50.4 and 0.4≦y≦0.5.

4. The light emitting device of claim 1 wherein the first and second layers are doped with an n-type dopant.

5. The light emitting device of claim 1 wherein at least one of the first and second layers is strained relative to a growth substrate on which the semiconductor structure is grown.

6. The light emitting device of claim 1 wherein the superlattice is lattice matched to a growth substrate on which the semiconductor structure is grown.

7. A method comprising:
growing an n-type superlattice (50) on a growth substrate (48), the superlattice comprising a plurality of stacked layer pairs;
growing a light emitting region (52) directly on the n-type superlattice;
growing a p-type region (54) on the light emitting region;
forming a first metal contact (60) on the p-type region;
removing the growth substrate to expose a surface of the superlattice; and
forming a second metal contact (34) directly on the exposed surface of the superlattice,
**characterised in that**
each layer pair comprises a first layer of AlₓGa₁₋ₓInP where 0.2≦x≦0.5 and a second layer of Al_{y}Ga_{1-y}InP where 0.3≦y≦0.65, the first layer having a smaller aluminum composition than the second layer.

8. The method of claim 7 further comprising lattice matching the superlattice to the growth substrate.

9. The method of claim 7 further comprising growing at least one of the first and second layers strained relative to the growth substrate.

10. The method of claim 7 further comprising roughening or patterning the exposed surface of the superlattice.

11. The method of claim 7 wherein forming a second metal contact directly on the exposed surface of the superlattice comprises:
forming a metal layer directly on the surface of the superlattice; and
patterning the metal layer to form a shaped second metal contact, the shape having a width no less than 1 micron and no greater 30 microns in a plan view.

12. The light emitting device of claim 7 wherein the superlattice layers are doped with a doping profile changing across the superlattice.

13. The light emitting device of claim 7 wherein the first layers are more highly doped than the second layers.

## Patentansprüche

1. Licht emittierende Vorrichtung, umfassend:
eine Halbleiterstruktur, die eine Licht emittierende III-P-Schicht (52) umfasst, die zwischen einer n-leitenden Region (50) und einer p-leitenden Region (54) angeordnet ist, wobei die n-leitende Region ein Supergitter umfasst; und
ein n-leitendes Kontaktmetall (34) auf und in Kontakt mit einer Oberfläche des Supergitters gegenüber der Licht emittierenden III-P-Schicht,
wobei das Supergitter eine Mehrzahl von gestapelten Schichtpaaren umfasst,
**dadurch gekennzeichnet, dass**
jedes Schichtpaar eine erste Schicht aus AlₓGa₁₋ₓInP, wobei 0,2 ≤ x ≤ 0,5, und eine zweite Schicht aus Al_{y}Ga_{1-y}InP, wobei 0,3 ≦ y ≦ 0,65, umfasst, wobei die erste Schicht eine kleinere Aluminiumzusammensetzung als die zweite Schicht aufweist.

2. Licht emittierende Vorrichtung nach Anspruch 1, ferner umfassend:
einen unteren Kontakt, der auf der p-leitenden Region angeordnet ist.

3. Licht emittierende Vorrichtung nach Anspruch 1, wobei 0,3 ≦ x ≦ 0,4 and 0,4 ≦ y ≦ 0,5.

4. Licht emittierende Vorrichtung nach Anspruch 1, wobei die erste Schicht und die zweite Schicht mit einer n-leitenden Dotierungssubstanz dotiert sind.

5. Licht emittierende Vorrichtung nach Anspruch 1, wobei mindestens eine der ersten und der zweiten Schicht in Bezug auf ein Wachstumssubstrat, auf welches die Halbleiterstruktur aufgewachsen ist, verspannt ist.

6. Licht emittierende Vorrichtung nach Anspruch 1, wobei das Supergitter an ein Wachstumssubstrat, auf welches die Halbleiterstruktur aufgewachsen ist, gitterangepasst ist.

7. Verfahren, umfassend:
Aufwachsen eines n-leitenden Supergitters (50) auf ein Wachstumssubstrat (48), wobei das Supergitter eine Mehrzahl von gestapelten Schichtpaaren umfasst;
Aufwachsen einer Licht emittierenden Region (52) direkt auf das n-leitende Supergitter;
Aufwachsen einer p-leitenden Region (54) auf die Licht emittierende Region;
Bilden eines ersten Metallkontakts (60) auf der p-leitenden Region;
Entfernen des Wachstumssubstrats, um eine Oberfläche des Supergitters freizulegen;
Bilden eines zweiten Metallkontakts (34) direkt auf der freigelegten Oberfläche des Supergitters,
**dadurch gekennzeichnet, dass**
jedes Schichtpaar eine erste Schicht aus AlₓGa₁₋ₓInP, wobei 0,2 ≦ x ≦ 0,5, und eine zweite Schicht aus Al_{y}Ga_{1-y}InP, wobei 0,3 ≦ y ≦ 0,65, umfasst, wobei die erste Schicht eine kleinere Aluminiumzusammensetzung als die zweite Schicht aufweist.

8. Verfahren nach Anspruch 7, ferner umfassend ein Gitteranpassen de Supergitters an das Wachstumssubstrat.

9. Verfahren nach Anspruch 7, ferner umfassend ein in Bezug auf das Wachstumssubstrat verspanntes Aufwachsen mindestens einer der ersten und zweiten Schicht.

10. Verfahren nach Anspruch 7, ferner umfassend ein Aufrauen oder Strukturieren der freigelegten Oberfläche des Supergitters.

11. Verfahren nach Anspruch 7, wobei das Bilden eines zweiten Metallkontakts direkt auf der freigelegten Oberfläche des Supergitters umfasst:
Bilden einer Metallschicht direkt auf der Oberfläche des Supergitters; und
Strukturieren der Metallschicht, um einen geformten zweiten Metallkontakt zu bilden, wobei die Form in Draufsicht eine Breite von nicht weniger als 1 Mikrometer und nicht mehr als 30 Mikrometer aufweist.

12. Licht emittierende Vorrichtung nach Anspruch 7, wobei die Supergitterschichten mit einem Dotierungsprofil dotiert sind, das sich über das Supergitter ändert.

13. Licht emittierende Vorrichtung nach Anspruch 7, wobei die ersten Schichten höher dotiert sind als die zweiten Schichten.

## Revendications

1. Dispositif électroluminescent comprenant :
une structure semi-conductrice comprenant une couche électroluminescente III-P (52) disposée entre une région de type n (50) et une région de type p (54), la région de type n comprenant un super-réseau, et
un métal de contact n (34) sur et en contact avec une surface du super-réseau opposée à la couche électroluminescente III-P,
le super-réseau comprenant une pluralité de paires de couches empilées,
**caractérisé en ce que** chaque paire comprend une première couche de AlₓGa₁₋ₓInP, où 0,2 ≦ x ≦ 0,5 et une seconde couche de Al_{y}Ga_{1-y}InP où 0,3 ≦ y ≦ 65, la première couche ayant une composition d'aluminium inférieure à la seconde couche.

2. Dispositif électroluminescent selon la revendication 1, comprenant en outre :
un contact de fond disposé sur la région de type p.

3. Dispositif électroluminescent selon la revendication 1, dans lequel 0,3 ≦ x ≦ 0,4 et 0,4 ≦ y ≦ 0,5.

4. Dispositif électroluminescent selon la revendication 1, dans lequel les première et seconde couches sont dopées avec un dopant de type n.

5. Dispositif électroluminescent selon la revendication 1, dans lequel au moins une des première et seconde couches est contrainte par rapport à un substrat de croissance sur lequel s'opère la croissance de la structure semi-conductrice.

6. Dispositif électroluminescent selon la revendication 1, dans lequel le super-réseau est un réseau apparié à un substrat de croissance sur lequel s'opère la croissance de la structure semi-conductrice.

7. Procédé comprenant :
la croissance d'un super-réseau de type n (50) sur un substrat de croissance (48), le super-réseau comprenant une pluralité de paires de couches empilées ;
la croissance d'une région électroluminescente (52) directement sur le super-réseau de type n ;
la croissance d'une région de type p (54) sur la région électroluminescente ;
la formation d'un premier contact métallique (60) sur la région de type p ;
l'élimination du substrat de croissance pour exposer une surface du super-réseau ; et
la formation d'un second contact métallique (34) directement sur la surface exposée du super-réseau,
**caractérisé en ce que**
chaque paire de couches comprend une première couche de AlₓGa₁₋ₓInP, où 0,2 ≦ x ≦ 0,5 et une seconde couche de Al_{y}Ga_{1-y}InP où 0,3 ≦ y ≦ 0,65, la première couche ayant une composition d'aluminium inférieure à la seconde couche.

8. Procédé selon la revendication 7, comprenant en outre un réseau appariant le super-réseau au substrat de croissance.

9. Procédé selon la revendication 7, comprenant en outre la croissance d'au moins une des première et seconde couches contraintes par rapport au substrat de croissance.

10. Procédé selon la revendication 7, comprenant en outre la rugosification ou le modelage de la surface exposée du super-réseau.

11. Procédé selon la revendication 7, dans lequel la formation d'un second contact métallique directement sur la surface exposée du super-réseau comprend :
la formation d'une couche métallique directement sur la surface du super-réseau ; et
le modelage de la couche métallique pour former un second contact métallique façonné, la forme ayant une largeur n'étant pas inférieure à 1 micron et pas supérieure à 30 microns sur une vue en plan.

12. Dispositif électroluminescent selon la revendication 7, dans lequel les couches de super-réseau sont dopées avec un profil de dopage changeant sur l'ensemble du super-réseau.

13. Dispositif électroluminescent selon la revendication 7, dans lequel les premières couches sont plus fortement dopées que les secondes couches.
